(19) Europäisches Patentamt
European Patent Office
Office européen des brevets

(11) EP 2 646 840 B1

(12) EUROPEAN PATENT SPECIFICATION

(45) Date of publication and mention
of the grant of the patent:
**14.11.2018 Bulletin 2018/46**

(51) Int Cl.:
**G01R 27/32** *(2006.01)* **G01R 35/00** *(2006.01)*

(21) Application number: **11784526.3**

(22) Date of filing: **28.09.2011**

(86) International application number:
**PCT/IT2011/000333**

(87) International publication number:
**WO 2012/042552 (05.04.2012 Gazette 2012/14)**

(54) **SYSTEM AND METHOD FOR DETERMINING THE GENERALIZED SCATTERING MATRIX OF A WAVEGUIDE DEVICE**

SYSTEM UND VERFAHREN ZUR BESTIMMUNG DER GENERALISIERTEN STREUMATRIX EINES WELLENLEITERS

SYSTÈME ET PROCÉDÉ POUR DÉTERMINER UNE MATRICE DE DIFFUSION GÉNÉRALISÉE D'UN DISPOSITIF DE GUIDE D'ONDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.09.2010 IT AN20100160**

(43) Date of publication of application:
**09.10.2013 Bulletin 2013/41**

(73) Proprietor: **Not Only Waves S.r.l.**
**60123 Ancona (IT)**

(72) Inventors:
• **MORINI, Antonio**
**60123 Ancona (AN) (IT)**
• **FARINA, Marco**
**60100 Ancona (AN) (IT)**

(74) Representative: **De Ros, Alberto et al**
**Notarbertolo & Gervasi S.p.A.**
**Corso di Porta Vittoria 9**
**20122 Milan (IT)**

(56) References cited:
EP-A2- 0 986 123          WO-A2-2005/069883
WO-A2-2007/147511     WO-A2-2008/021885
JP-A- 2002 243 429        US-A1- 2003 173 978
US-A1- 2004 051 538     US-A1- 2004 201 383
US-B1- 6 407 542

• **FARINA M ET AL: "On the derivation of coupled-line models from EM simulators and application to MoM analysis", IEEE TRANSACTIONS ON MICROWAVE THEORY AND TECHNIQUES, vol. 53, no. 11, November 2005 (2005-11), pages 3272-3280, XP002643402, IEEE USA ISSN: 0018-9480**
• **FARINA M ET AL: "On the extension of commercial planar circuit CAD packages to the analysis of two-port waveguide components", INTERNATIONAL JOURNAL OF RF AND MICROWAVE COMPUTER-AIDED ENGINEERING, vol. 13, no. 2, March 2003 (2003-03), pages 113-117, XP002665950, WILEY USA ISSN: 1096-4290**
• **UHER J ET AL: "WAVEGUIDE COMPONENTS FOR ANTENNA FEED SYSTEMS : THEORY AND CAD", 1 January 1993 (1993-01-01), WAVEGUIDE COMPONENTS FOR ANTENNA FEED SYSTEMS: THEORY AND CAD, XX, XX, PAGE(S) 420 - 427, XP002171252, cited in the application figure 3.8.31**

**Description**

*Field of invention*

The present invention relates to the multimodal measurement of waveguide devices, characterized in the fact that their ports are waveguides, that is hollow metallic pipes of arbitrary cross-sections. [Collin, Field Theory of Guided Waves, IEEE Press 1992].

The most common cross sections are rectangular, circular, and coaxial, but even waveguides of different cross-sections are used [Marcuvitz, 'Waveguide Handbook', Peter Peregrinus, 1987; Montgomery, Dicke and Purcell, 'Principles of Microwave Circuits', Peter Peregrinus, 1987].

The present invention can be used for measuring waveguide devices, whose ports are waveguides having fully arbitrary cross-section.

*State of Art*

From a theoretical viewpoint, it is well known that, for a given frequency, within a waveguide only a discrete number of waves can propagate, each one characterized by a definite field distribution and by a specific propagation constant [Marcuvitz]. Such waves are called MODES and each mode is characterized by its own cutoff frequency beyond which it can propagate. On the other hand, waveguides are typically dimensioned to be monomodal at the operating frequency, that is their dimensions are compatible with one single propagating mode, called 'fundamental mode'. Other modes are called higher order modes. The frequency band in which only the fundamental mode propagates is defined as monomodal band. In the monomodal band a vector electromagnetic problem becomes scalar, in as much as the electromagnetic field transverse with respect to the propagation direction has a distribution known and rigid, that does not change along the waveguide. The measurement methods nowadays available in the market work in the monomodal band. However, there are situations in which such an hypothesis falls. A very representative case is constituted by a waveguide low-pass filter, which needs to be experimentally characterized in the whole stop-band, well above the monomodal band where the pass-band is located. The measurement above such a limit is currently done by using two tapered waveguides (transitions) interfacing the filter ports to waveguides featuring smaller transverse section, so that they are monomodal in the measurement band. Although adopted everywhere, such a technique suffers from an important drawback, because said transitions are almost transparent for the fundamental mode, but they behave as reactive loads for the higher order modes, potentially above cut-off in the filter stop-band. Hence the measurement is roughly acceptable for the fundamental mode, but is not correct for the higher order modes, that could be generated by the presence of a bend or of whatever discontinuity [Collin]. There are other very common situations in which monomodality cannot intrinsically exist such as, for example, in circular and square waveguides, where there are at least two fundamental modes, called degenerate, which have the same propagation constant but different polarization. In such a case, the two modes are usually measured separately by placing the device under test (Device Under Test DUT) between two ortho-mode transducers (Ortho-mode Transducers OMT) [J. Uher, J. Bornemann and U. Rosenberg, Waveguide. Components for Antenna Feed Systems: Theory and CAD, Artech House, Norwood: 1993] and by measuring the two polarizations separately. The systematic measurement error introduced by the OMT cannot be removed, because there is no way to measure accurately an OMT, since its circular (or square) port cannot be directly connected to the monomodal ports of a Vector Network Analyzer (Vector Network Analyzer - VNA), the instrument typically used for microwave measurements, because there are two propagating degenerate modes. Hence the measurement accuracy relies on the quality of the OMTs, in particular for what concerns the isolation between the orthogonal polarizations. Such reasons led to the development of a measurement system and a procedure for measuring several modes in waveguide. Said system and said procedure are the object of the invention.

The art of measuring, by means of a Vector Network Analyzer (VNA), the scattering matrix of linear devices featuring monomodal ports is well known by those who work in microwaves. With the advent of the multiport Vector Network Analyzers (VNA), characterized by possessing a predefined number of monomodal ports (greater than two), to which a device can be connected in order to perform simultaneously measurements at different monomodal ports, some authors have considered the issue of the measurement of balanced devices. The simplest case is the one of two parallel strips or wires, electromagnetically coupled, as it happens in Cohn's directional coupler [I. Bahl, P. Bhartia , Microwave Solid State Circuit Design, Wiley, 2003]. The scattering matrix of such a 4-port device can be measured when it is connected to Vector Network Analyzer (VNA) by means of unbalanced ports. Anderson filed a patent application concerning both system and method to obtain the mixed mode scattering matrix ('Balanced device characterization including test system calibration', US 2004/201383, Anderson Keith F, 14 October 2004). In summary the application, which specifically refers to the case of a 4-port device under test (DUT), assumes the possibility to measure by means of known techniques the scattering matrix of a 4-port device embedded in a network containing at least a 4-port $(\Sigma, \Delta, 1, 2)$ hybrid coupler (HJC) and possibly, a test fixture interfacing the system to the device under test (DUT). A signal entering

port $\Sigma$ is split in two equiphase and equiamplitude signals at ports 1 and 2. On the contrary, a signal entering port $\Delta$ is split in two equiamplitude signals, having 180° phase difference from each other, at ports 1 and 2. The algorithm implemented in the controller driving the measurement allows to transform the scattering matrix of the device under test (DUT), measured at the unbalanced ports, to the mixed mode one, in which the two ports are balanced. The calibration procedure is the same used in standard measurements because all the devices of the measurement system are interfaced through standard unbalanced connectors and consequently they are measured and characterized by means of known techniques. The invention provides, after removing the systematic error due to the presence of the HJC and of the test fixture, by means of a standard procedure, the mixed mode scattering matrix of the 4-port device under test.

Note that such an invention is based on a calibration scheme assuming that each port is a classic unbalanced coaxial port. Hence it can still work when ports are monomodal waveguides, other than coaxial waveguides. However the invention cannot work when the HJC ($\Sigma$, $\Delta$, 1, 2) or the test fixture or part of them are multimodal waveguides, as in the object of the present invention, because the aforementioned ports cannot be connected to a Vector Network Analyzer (VNA).

*Summary of the Invention*

The present invention makes possible the measurement of the Generalized Scattering Matrix (GSM) of a device under test (DUT) whose physical ports are multimodal waveguides by means of a Vector Network Analyzer (VNA) having two or more physical ports which are monomodal waveguides.

The present invention is defined by the claims here attached forming integral part of the present description. The idea behind the present invention is that of using a component, or "converter", which transforms a multimodal port into a plurality of monomodal ports, to connect it to the device under test (if the device under test features more than one multimodal port, more than one converter will be necessary), and to perform measurements of the scattering parameters of the components so connected; in order to rebuild the generalized scattering matrix of the device under test it will be necessary to perform a set of processing. Typically, such processing will require the knowledge or the measurement of the scattering parameters of the converters).

*Brief description of the figures*

The present invention will be better described by some preferred embodiments, provided as example and not limited to, with reference to the attached drawings, wherein:

Fig. 1 shows a block diagram of a system according to the present invention,
Fig.2 shows three plane views of a first converter that can be used for the present invention,
Fig.3 shows a perspective view of a second converter that can be used for the present invention,
Fig.4 shows a perspective view of a third converter that can be used for the present invention, and
Fig.5 shows a flowchart of a method according to the present invention.

*Detailed description*

Both this description and these drawings are to be considered for illustrative purposes only and therefore not limited to; hence, the present invention may be implemented according to other and different embodiments. In addition, it has to be considered that these figures are schematic, simplified and out of scale as it is clear to a skilled in the field.

Following a detailed description of the figures.

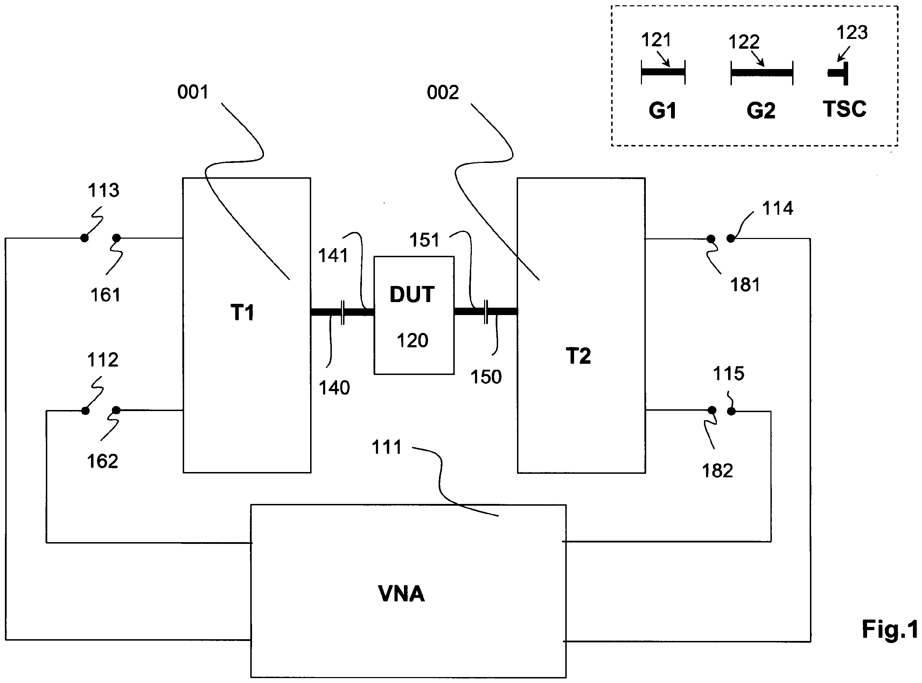

Fig. 1 shows a scheme of the measurement set up, in a preferred embodiment relative to a two-mode measurement, including two converters, 001 e 002, which transform a predefined number Na (2 in Fig.1) of distinct monomodal ports into a single multimodal port, where the same predefined number Na of modes are above cut-off (being, for the converter 001, the monomodal ports 161 and 162, and the multimodal port 140, while for converter 002 being the monomodal ports 181 and 182 and the multimodal port 150). The device under test (DUT) (120) is connected through its multimodal ports (141 and 151) to the multimodal ports (140 e 150) of converters (001, 002). The set up also includes a Vector Network Analyzer (VNA) (111), whose monomodal ports (112,113,114, 115) are connected to said monomodal ports (161, 162, 181, 182) of the converters. The scheme also works when the Vector Network Analyzer (VNA) possesses only two ports for the connection to the monomodal ports of the converters. In this case some independent measurements are needed (in number of Na·(Na-1)/2), considering two ports at a time, while the monomomdal ports of the converters 001 and 002 not connected to the VNA (111) have to be loaded by matched loads.

The calibration kit is formed by two sections of multimodal waveguides (121 e 122), having the same transverse cross-section as the multimodal ports (140, 150) of the converters (001, 002) to which they can be connected without discontinuity, and one shifted short circuit (123). The length of the two waveguide sections are different from each other.

Once the calibration is done, by measuring the sections (121, 122) and the shifted short circuit (123), according to the method described in the following, the device under test (DUT) (120) is connected to the multimodal ports (140, 150) of the converters (001,002) through its multimodal ports (141, 151). The monomodal ports (161,162,181,182) of the converters (001,002) are connected to the ports (112,113,114,115) of the Vector Network Analyzer (VNA) (111); when the number of ports of said Vector Network Analyzer (VNA) (111) is less than 2Na, the ports of the device under test not connected to the Vector Network Analyzer (VNA) (111) have to be connected to matched loads, as required by the measurement of the scattering matrix [Collin].

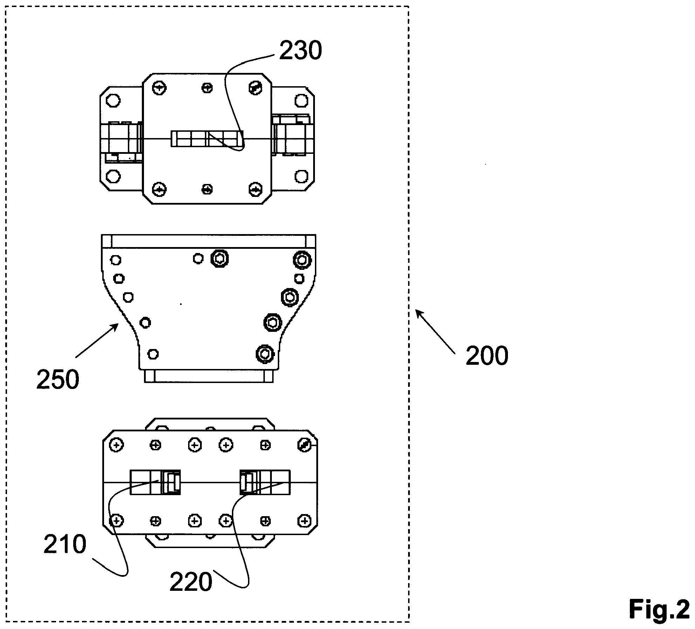

Fig. 2 shows a converter (200) connecting two monomodal rectangular waveguides (210, 220, mode TE10) to a bimodal waveguide (230, modes TE10, TE20), to be used in a preferred embodiment of the present invention; the upper view is a first front view, the central view (250) is a top view and the lower view is a second front view. The two monomodal waveguides (210, 220) are ports to be connected to the Vector Network Analyzer (VNA) (111), through which the monomodal measurement is performed. In fact, each bimodal port of the device under test (DUT) (120) cannot be measured directly, namely by direct connection to the ports of the Vector Network Analyzer (VNA) (111), due to the presence of two modes above cut-off, which make the shape of the electromagnetic field dependent on the section considered within the waveguide. Thus the experimental characterization of the converters cannot be performed by known techniques and requires the application of the scheme object of the present invention. This scheme has never been presented before and is completely original. Although the figures refer to a bimodal case, the invention is not limited to two modes. The only requirements for the converters are that the number of modes propagating at the single multimodal port is the same as the number of monomodal ports and that each monomodal port is, at least, electromagnetically coupled to one mode of the multimodal port. In other words, in the converter there must be energy transfer among each single mode supported by monomodal ports and at least one of the modes supported by the multimodal port.

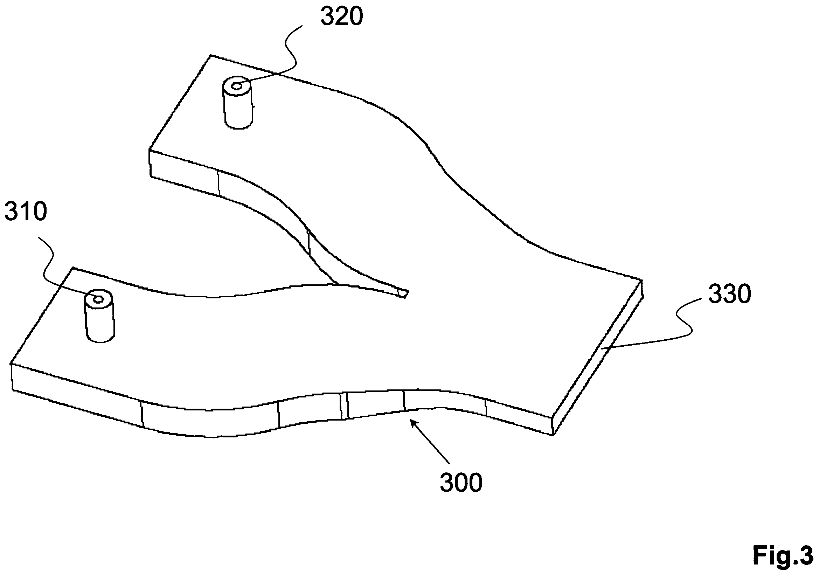

Fig. 3 shows another preferred embodiment of the present invention, where the monomodal waveguide ports of the converter (300) are connectorized through monomodal coaxial connectors (310 e 320). The multimodal port (330) is electromagnetically coupled to both modes propagating in the coaxial ports (310, 320).

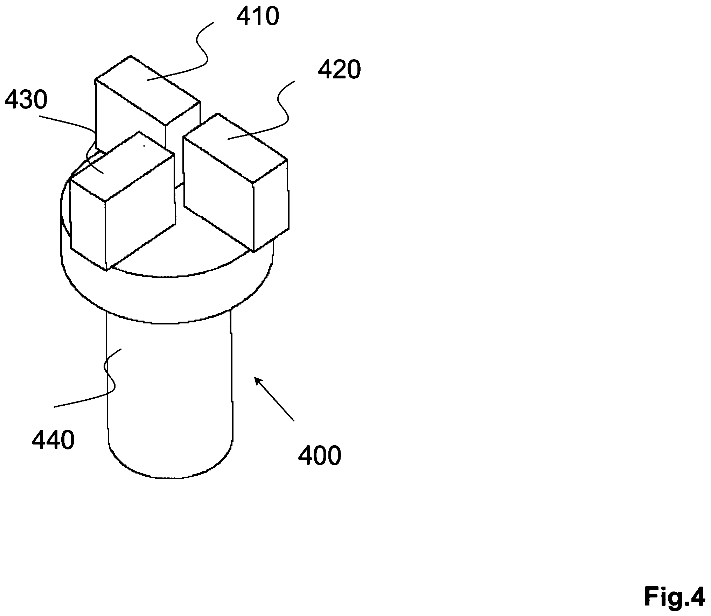

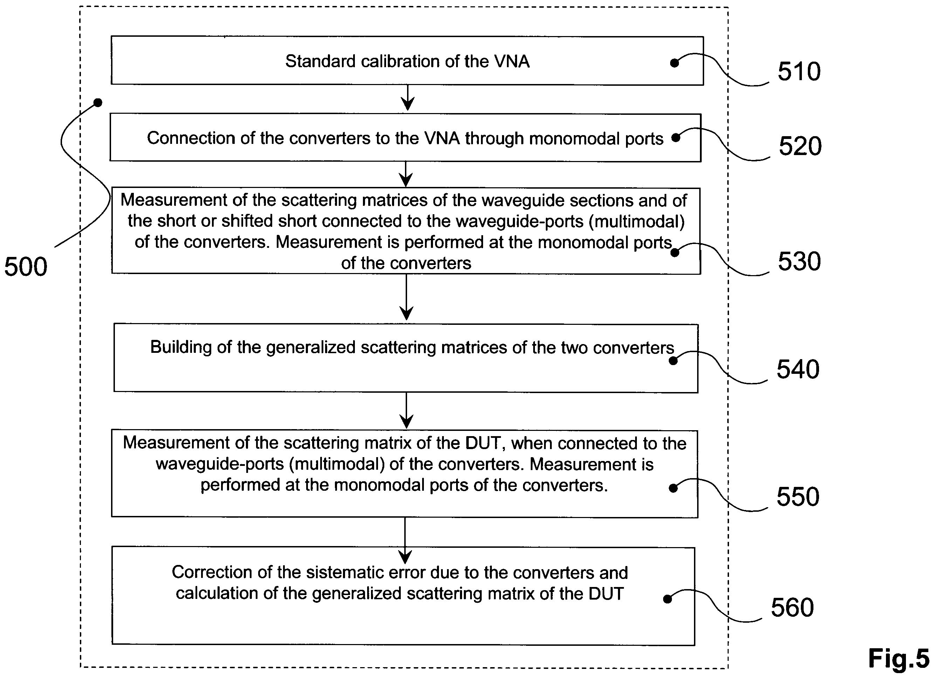

Fig. 4 shows a further embodiment of the present invention, where the converter (400) connects 3 rectangular monomodal waveguides (TE10) (410, 420, 430) to a trimodal circular waveguide (TE11V+TE11H+TM01) (440). The three monomodal waveguides are the ports which the Vector Network Analyzer (VNA) is connected to. The circular waveguide (440) could be replaced by a square waveguide, without changing the invention. Fig. 5 shows the flowchart (500) of the measurement steps involved in the object of the present invention including 1) Calibration of the Vector Network Analyzer (VNA) (111) at the ports that have to be connected to the monomodal ports of the converters, by means of the standard monomodal calibration (510); 2) Connection of the converters to the ports of the Vector Network Analyzer (VNA) (111) through their monomodal ports (520); 3) Measurement of the scattering matrix of the multimodal waveguide sections having predefined lengths and of the shifted short circuit, when inserted between the two converters, performed by means of the Vector Network Analyzer (VNA) (111), connected to the monomodal ports of the converters (530); 4) Construction of the generalized scattering matrices, or of equivalent representations, of the two converters (540); 5) Measurement of the scattering matrix of the DUT (120) when it is inserted between the two converters, performed by means of the Vector Network Analyzer (VNA) (111), connected to the monomodal ports of the converters (550); 6) Correction of the systematic error due to the converters and calculation of the generalized scattering matrix (GSM), or of an alternative representation, of the device under test (DUT) (120) (560).

A system according to the present invention is described in the following, with indicative but not binding reference to the figures, in a synthetic way, highlighting first the more important technical features and then the more profitable ones.

The system allows to determine the generalized scattering matrix (GSM) of a waveguide device (DUT); the device (DUT) features at least a first (141) and a second waveguide-port (151) each one corresponding to a multimodal port, said waveguide-ports (141, 151) allowing the propagation of a number of modes Na greater than or equal to two.

This system includes:

- a vector network analyzer (VNA) adapted to measure the scattering parameters and featuring at least a first group (112, 113) and a second group (114, 115) of waveguide-ports, each corresponding to a monomodal port,
- conversion means (T1, T2) adapted to interface the multimodal ports (141, 151) of said device (DUT) to the monomodal ports (112, 113, 114, 115) of said analyzer (VNA) when the system is used for the determination, and
- storage and data processing means adapted to perform the calculation of the generalized scattering matrix (GSM) of said waveguide device (DUT) on the basis of measured data of scattering parameters performed by means of said analyzer (VNA) and then stored, and on the basis of pre-stored calibration data.

Note that the special case of a particular group of just one waveguide-port also falls under the expression "group of waveguide-ports".

Said conversion means can include at least or only:

- a first converter (T1) featuring one waveguide-port (140) for the connection to said first waveguide-port (141) of said device (DUT) and of a number of waveguide-ports (161, 162) equal to said number Na for the connection to said analyzer (VNA), and
- a second converter (T2) featuring one waveguide-port (150) for the connection to said second waveguide-port (151) of said device (DUT) and of a number of waveguide-ports (181, 182), equal to said number Na, for the connection to said analyzer (VNA).

In this system, typically and advantageously,:

- said waveguide-port (140) of said first converter (T1) for the connection to the device (DUT) is a physical port corresponding to a plurality of electrical ports and it consists of a multimodal waveguide where said Na modes, corresponding to Na electrical ports, can propagate,
- said number of waveguide-ports (161, 162) of said first converter (T1) for the connection to the analyzer (VNA) are physical ports corresponding to as many electrical ports and consist of monomodal ports respectively,
- said waveguide-port (150) of said second converter (T2) for the connection to the device (DUT) is a physical port corresponding to a plurality of electrical ports and it consists of a multimodal waveguide where said Na modes, corresponding to Na electrical ports, can propagate, and
- said number of waveguide-ports (181, 182) of said second converter (T2) for the connection of the analyzer (VNA) are physical ports corresponding to as many electrical ports and consist of monomodal ports respectively.

In this system typically and advantageously:

- the transverse cross section of the multimodal waveguide (140) of said first converter (T1) is equal to the transverse cross section of the multimodal waveguide (150) of said second converter (T2).

In this system, typically and advantageously:

- the transverse cross section of the monomodal waveguides (161, 162) of said first converter (T1) is equal to the transverse cross section of the monomodal waveguides (181, 182) of said converter (T2).

In this system, typically and advantageously:

- the transverse cross section of the monomodal waveguides (161, 162) of said first converter (T1) is equal to the transverse cross section of the waveguide-ports (112, 113) of said Vector Network Analyzer (VNA), and
- the transverse cross section of the monomodal waveguides (181,182) of said second converter (T2) is equal to the transverse cross section of the waveguide-ports (114, 115) of said Vector Network Analyzer (VNA). This system can further include a calibration kit; such a calibration kit comprises:
- a first waveguide section (G1) in which electromagnetic waves propagate according to Na propagation modes and having a first length, the generalized scattering matrix of said first section being predetermined, in particular pre-calculated or pre-measured,
- a second waveguide section (G2) in which electromagnetic waves propagate according to Na propagation modes and having a second length, the generalized scattering matrix of said second section being predetermined, in particular pre-calculated or pre-measured,
- at least a waveguide element realizing a "shifted short circuit" (TSC), the generalized scattering matrix of said "shifted short circuit" being predetermined, in particular pre-calculated or pre-measured,

note that said first length is different from said second length and that the particular case of "zero shift" also falls under the expression "shifted short circuit".

In this system, typically and advantageously:

- the transverse cross section of said first waveguide section (G1) is equal to the transverse cross section of said second waveguide section (G2), to the transverse cross section of the multimodal waveguide (140) of said first converter (T1), and to the cross section (150) of the multimodal waveguide of said second converter (T2),
- the transverse cross section of said second waveguide section (G2) is equal to the transverse cross section of said first waveguide section (G1), to the transverse cross section of the multimodal waveguide (140) of said first converter (T1), and to the transverse cross section of the multimodal waveguide (150) of said second converter (T2), and
- the transverse cross section of said waveguide element which realizes a "shifted short circuit" (TSC) is equal to the transverse cross section of the multimodal waveguide (140) of said first converter (T1), and to the transverse cross section of the multimodal waveguide (150) of said second converter (T2).

A method according to the present invention is described in the following, with reference indicative but not binding to the figures, in a synthetic way, highlighting the most important technical features first, and then the advantageous ones.

The method is used to determine the generalized scattering matrix (GSM) of a waveguide device (DUT); the device (DUT) features at least a first and a second waveguide-port each corresponding to a multimodal port; the method is implemented by means of a vector network analyzer (VNA) featuring at least a first and a second waveguide-port (advantageously a first group and a second group of waveguide-ports) each corresponding to a monomodal port, and by means of a first and a second converter (T1, T2) which allow interfacing between the multimodal ports of said device (DUT) and the monomodal ports of said analyzer (VNA).

This method includes the following steps:

A) connecting said first converter (T1) between the first waveguide-port of said device (DUT) and the first group of waveguide-ports of said analyzer,

B) connecting said second converter (T2) between the second waveguide-port of said device (DUT) and the second group of waveguide-ports of said analyzer,

C) performing a measurement of the scattering parameters by means of said analyzer (VNA) of the connection between said device (DUT) and said first and second converters (T1, T2),

D) processing the results of said measurement and the generalized scattering matrices of said first and second converters (T1, T2) obtaining the generalized scattering matrix (GSM) of said device (DUT).

This method typically involves that said analyzer (VNA) is preliminarily calibrated in a way independent of said device (DUT) and of said first and second converters (T1, T2).

Said analyzer (VNA) can be calibrated in the frequency band of interest for example by using the procedure Thru-Reflect-Line (TRL) or Short-Open-Load-Thru (SOLT) or other standard procedures.

According to this method, the generalized scattering matrices of said first and second converters (T1, T2) will be typically determined by means of a preliminary calibration procedure dependent on said first and second converters (T1, T2) and independent of said device (DUT).

Said calibration procedure typically includes the following phases:

- connection of said first and second converters (T1, T2) to said analyzer (VNA) through their monomodal ports, connection of said first and second converters (T1, T2) by placing a first waveguide section (G1), having a first length, in between their multimodal ports, and measurement of the scattering parameters of the scattering matrix $\mathbf{S}_1$ by means of said analyzer (VNA) and their storage in a memory either external or internal to said analyzer (VNA),

- connection of said first and second converters (T1, T2) respectively to said analyzer (VNA) by means of the monomodal ports, connection of said first and second converters (T1, T2) by placing a second waveguide section (G2), having a second length, in between their multimodal ports, and measurement of the scattering parameters of the scattering matrix $\mathbf{S}_2$ by means of said analyzer (VNA) and their storage in a memory either external or internal to said analyzer (VNA),

- connection of said first or second converter (T1, T2) directly to said analyzer (VNA) by means of the monomodal ports, connection of said first or second converter (T1, T2) directly to a waveguide element realizing a "shifted short circuit" (TSC) by means of the multimodal port, and measurement of the scattering parameters of a scattering matrix $\Gamma$ by means of said analyzer (VNA) and their storage in a memory either external or internal to said analyzer (VNA).

Note that the particular case "zero shift" also falls under the expression "shifted short circuit"

More specifically, said calibration procedure includes advantageously the following phases:

I) measuring the scattering parameters of the scattering matrix $\mathbf{S}_1$ and calculating the wave matrix $\mathbf{W}_1$, which corresponds to the scattering matrix $\mathbf{S}_1$, the wave matrix $\mathbf{W}$ being related to the scattering matrix $\mathbf{S}$ by the relationship

$$\mathbf{W}=\begin{bmatrix}\mathbf{W}_{11} & \mathbf{W}_{12}\\ \mathbf{W}_{21} & \mathbf{W}_{22}\end{bmatrix}=\begin{bmatrix}\mathbf{S}_{21}^{-1} & -\mathbf{S}_{21}^{-1}\cdot\mathbf{S}_{22}\\ \mathbf{S}_{11}\cdot\mathbf{S}_{21}^{-1} & \mathbf{S}_{12}-\mathbf{S}_{11}\cdot\mathbf{S}_{21}^{-1}\cdot\mathbf{S}_{22}\end{bmatrix}$$

, where $\mathbf{S}_{ij}$ is the block $ij$ (NaxNa) of the matrix $\mathbf{S}$ (2Nax2Na) and $\mathbf{W}_{ij}$ is the block $ij$ (Na×Na) of the matrix $\mathbf{W}$ (2Na×2Na),

II) measuring the scattering parameters of the scattering matrix $\mathbf{S}_2$ and calculating the wave matrix $\mathbf{W}_2$, corresponding

to the scattering matrix $\mathbf{S}_2$, the wave matrix $\mathbf{W}$ being related to the scattering matrix $\mathbf{S}$ by the relationship

$$\mathbf{W} = \begin{bmatrix} \mathbf{W}_{11} & \mathbf{W}_{12} \\ \mathbf{W}_{21} & \mathbf{W}_{22} \end{bmatrix} = \begin{bmatrix} \mathbf{S}_{21}^{-1} & -\mathbf{S}_{21}^{-1} \cdot \mathbf{S}_{22} \\ \mathbf{S}_{11} \cdot \mathbf{S}_{21}^{-1} & \mathbf{S}_{12} - \mathbf{S}_{11} \cdot \mathbf{S}_{21}^{-1} \cdot \mathbf{S}_{22} \end{bmatrix},$$ where $\mathbf{S}_{ij}$ is the block $ij$ (NaxNa) of the matrix $\mathbf{S}$

and $\mathbf{W}_{ij}$ is the block $ij$ (Na×Na) of the matrix $\mathbf{W}$ (2Na×2Na),

III) performing the product between the matrix $\mathbf{W}_1$ and the inverse of the matrix $\mathbf{W}_2$, obtaining the matrix $\mathbf{W}_1 \mathbf{W}_2^{-1}$,

IV) calculating the eigenvalues and the corresponding eigenvectors of the matrix $\mathbf{W}_1 \mathbf{W}_2^{-1}$,

V) sorting the eigenvalues and the corresponding eigenvectors in the same order as the eigenvalues, analytically known, of the wave matrix of a multimodal waveguide section, having the same transverse cross section of said first and second waveguide sections (G1, G2) and length equal to the difference between said first length and said second length,

VI) building the matrix $\mathbf{W}_L'$, whose columns are said eigenvectors, sorted according to the order of the known eigenvalues sorted as in phase V,

VII) measuring the scattering parameters of the scattering matrix $\Gamma$,

VIII) calculating the matrix

$$\mathbf{Q}_L = \left( \mathbf{W}_{L_{22}}' - \Gamma \ \mathbf{W}_{L_{12}}' \right)^{-1} \cdot \left( \Gamma \ \mathbf{W}_{L_{11}}' - \mathbf{W}_{L_{21}}' \right) \cdot \Gamma_L$$

where $\mathbf{W}_{L_{ij}}'$ is the block $ij$ (Na×Na) of the matrix $\mathbf{W}_L'$ while $\Gamma_L$ is the generalized scattering matrix (Na×Na) of said "shifted short circuit" (TSC), known because pre-calculated or pre-measured.

Said steps C and D involve advantageously and specifically:

IX) measuring the scattering parameters of a scattering matrix $\mathbf{S}_{raw}$ when said device (DUT) is connected to said first and second converters (T1, T2) at the monomodal ports of said first and second converters (T1, T2), and transforming the scattering matrix $\mathbf{S}_{raw}$ in the corresponding wave matrix $\mathbf{W}_{raw}$, the wave matrix $\mathbf{W}$ being related to

the scattering matrix $\mathbf{S}$ by the relationship $\mathbf{W} = \begin{bmatrix} \mathbf{W}_{11} & \mathbf{W}_{12} \\ \mathbf{W}_{21} & \mathbf{W}_{22} \end{bmatrix} = \begin{bmatrix} \mathbf{S}_{21}^{-1} & -\mathbf{S}_{21}^{-1} \cdot \mathbf{S}_{22} \\ \mathbf{S}_{11} \cdot \mathbf{S}_{21}^{-1} & \mathbf{S}_{12} - \mathbf{S}_{11} \cdot \mathbf{S}_{21}^{-1} \cdot \mathbf{S}_{22} \end{bmatrix},$ where

$\mathbf{S}_{ij}$ is the block $ij$ (Na×Na) of the matrix $\mathbf{S}$ (2Nax2Na), and $\mathbf{W}_{ij}$ is the block $ij$ (Na×Na) of the matrix $\mathbf{W}$(2Na×2Na),

X) calculating the wave matrix $\Omega' = \mathbf{W}_L'^{-1} \cdot \mathbf{W}_{raw} \cdot \mathbf{W}_L'$ and transforming it in the corresponding scattering matrix $\mathbf{S}'$ by means of the equation:

$$\mathbf{S} = \begin{bmatrix} \mathbf{S}_{11} & \mathbf{S}_{12} \\ \mathbf{S}_{21} & \mathbf{S}_{22} \end{bmatrix} = \begin{bmatrix} \mathbf{W}_{21} \cdot \mathbf{W}_{11}^{-1} & \mathbf{W}_{22} - \mathbf{W}_{21} \cdot \mathbf{W}_{11}^{-1} \cdot \mathbf{W}_{12} \\ \mathbf{W}_{11}^{-1} & \mathbf{W}_{11}^{-1} \cdot \mathbf{W}_{12} \end{bmatrix},$$ where $\mathbf{S}_{ij}$ is the block $ij$

(Na×Na) of the matrix $\mathbf{S}$ (2Na×2Na), and $\mathbf{W}_{ij}$ is the block $ij$(Na×Na) of the matrix $\mathbf{W}$(2Na×2Na),

XI) rebuilding the generalized scattering matrix (GSM) of said converter (DUT), whose blocks are given by the following expressions: reciprocal device case:

$$\left( \mathbf{S}_{11} \right)_{ij} = \pm \sqrt{ \left( \mathbf{S}_{11}' \mathbf{Q}_L^{-1} \right)_{ij} \cdot \left( \mathbf{S}_{11}' \mathbf{Q}_L^{-1} \right)_{ji} }$$

$$\left(\mathbf{S}_{12}\right)_{ij} = \pm\sqrt{\left(\mathbf{S}_{12}'\right)_{ij} \cdot \left(\mathbf{Q}_L\mathbf{S}_{21}'\mathbf{Q}_L^{-1}\right)_{ji}}$$

$$\left(\mathbf{S}_{22}\right)_{ij} = \pm\sqrt{\left(\mathbf{Q}_L\mathbf{S}_{22}'\right)_{ij} \cdot \left(\mathbf{Q}_L\mathbf{S}_{22}'\right)_{ji}}$$

$$\left(\mathbf{S}_{21}\right)_{ij} = \left(\mathbf{S}_{12}\right)_{ji}$$

non-reciprocal device case:

$$\left(\mathbf{S}_{11}\right)_{ij} = \pm\sigma_{ij}\left(\mathbf{S}_{11}'\mathbf{Q}_L^{-1}\right)_{ij}$$

$$\left(\mathbf{S}_{12}\right)_{ij} = \pm\sigma_{ij}\left(\mathbf{S}_{12}'\right)_{ij}$$

$$\left(\mathbf{S}_{21}\right)_{ij} = \pm\sigma_{ij}\left(\mathbf{Q}_L\mathbf{S}_{21}'\mathbf{Q}_L^{-1}\right)_{ij}$$

$$\left(\mathbf{S}_{22}\right)_{ij} = \pm\sigma_{ij}\left(\mathbf{Q}_L\mathbf{S}_{22}'\right)_{ij}$$

where $\sigma_{ij} = \sqrt{\left(\mathbf{S}_{11}''\mathbf{Q}_L^{-1}\right)_{ji} \Big/ \left(\mathbf{S}_{11}''\mathbf{Q}_L^{-1}\right)_{ij}}$, being $\mathbf{S}_{11}''$ the block 11 (Na×Na), of the scattering matrix, calculated as described in X, of a further reciprocal device independent, separately measured, typically preliminarily.

Hence, in case one wants to determine the generalized scattering matrix of a non-reciprocal device, they have to determine the generalized scattering matrix of a (different and whatsoever) reciprocal device, typically by using a first time the method according to the present invention, in such a way to get the parameters $\sigma_{ij}$, and then to determine the generalized scattering matrix of the non-reciprocal device of interest, typically using a second time the method according to the present invention.

The uncertainty about the sign highlighted by the previous formulas, namely the 180° degree phase uncertainty, does not poses any issue, as known to skilled in the field.

In any case, the diagonal terms of said generalized scattering matrix (GSM) are given by the following expressions:

$$(\mathbf{S}_{11})_{ii} = (\mathbf{S}_{11}'\mathbf{Q}_L^{-1})_{ii}$$

$$(\mathbf{S}_{12})_{ii} = (\mathbf{S}_{12}')_{ii}$$

$$(\mathbf{S}_{21})_{ii} = (\mathbf{Q}_L \mathbf{S}'_{21} \mathbf{Q}_L^{-1})_{ii}$$

$$(\mathbf{S}_{22})_{ii} = (\mathbf{Q}_L \mathbf{S}'_{22})_{ii}$$

This method can be implemented by means of an analyzer (VNA) featuring a number of waveguide-ports corresponding to monomodal ports, equal to twice the number Na of propagating modes, which can propagate through the multimode ports of said device (DUT). Alternatively, this method can be implemented by means of an analyzer (VNA) featuring only two monomodal waveguide-ports; in this case, said only two waveguide-ports are connected according to all the possible combinations, being specifically Na×(Na1)/2, to said monomodal waveguide-ports of said first and second converters (T1, T2) repeating the measurement of the scattering parameters.

**Claims**

1. System for determination of a generalized scattering matrix (GSM) of a hollow conducting waveguide device (DUT), said device (DUT) having at least a first (141) and a second (151) hollow conducting waveguide ports each being a multimodal port allowing propagation of a number of propagating modes Na greater than or equal to two; the system comprising :

   - a vector network analyzer (VNA) adapted to measure scattering parameters and having at least a first group (112, 113) and a second group (114, 115) of waveguide ports, each being a monomodal port allowing propagation of one propagating mode,
   - conversion means (T1, T2) adapted to interface the hollow conducting waveguide ports (141, 151) of said device (DUT) to the waveguide ports (112, 113, 114, 115) of said analyzer (VNA) when the system is used for the determination, and
   - storage and data processing means adapted to perform calculation of the generalized scattering matrix (GSM) of said hollow conducting waveguide device (DUT) according to data of scattering parameters measured by means of said analyzer (VNA) and then stored, and according to pre-stored calibration data;

   wherein said conversion means (T1, T2) comprise at least:

   - a first converter (T1) having a hollow conducting waveguide port (140) for connection to said first hollow conducting waveguide port (141) of said device (DUT) and a number of waveguide ports (161, 162) equal to said number Na for connection to said analyzer (VNA), and
   - a second converter (T2) having a hollow conducting waveguide port (150) for connection to said second hollow conducting waveguide port (151) of said device (DUT) and a number of waveguide ports (181, 182) equal to said number Na for connection to said analyzer (VNA).

2. System according to claim 1, wherein:

   - said waveguide-port (140) of said first converter (T1) for the connection to the device (DUT) is a physical port corresponding to a plurality of electrical ports and it consists of a multimodal waveguide where said Na modes, corresponding to Na electrical ports, can propagate,
   - said number of waveguide-ports (161, 162) of said first converter (T1) for the connection to the analyzer (VNA) are physical ports corresponding to as many electrical ports and consist of monomodal ports respectively,
   - said waveguide-port (150) of said second converter (T2) for the connection to the device (DUT) is a physical port corresponding to a plurality of electrical ports and it consists of a multimodal waveguide where said Na modes, corresponding to Na electrical ports, can propagate, and
   - said number of waveguide-ports (181, 182) of said second converter (T2) for the connection of the analyzer (VNA) are physical ports corresponding to as many electrical ports and consist of monomodal ports respectively.

3. System according to claims 1 or 2, wherein:

   the transverse cross section of the multimodal waveguide (140) of said first converter (T1) is equal to the transverse cross section of the multimodal waveguide (150) of said second converter (T2).

4. System according to claims 1 or 2 or 3, wherein:

- the transverse cross section of the monomodal waveguides (161, 162) of said first converter (T1) is equal to the transverse cross section of the monomodal waveguides (181, 182) of said converter (T2).

5. System according to claims 1 or 2 or 3 or 4, wherein:

- the transverse cross section of the monomodal waveguides (161, 162) of said first converter (T1) is equal to the transverse cross section of the waveguide-ports (112, 113) of said Vector Network Analyzer (VNA), and
- the transverse cross section of the monomodal waveguides (181,182) of said second converter (T2) is equal to the transverse cross section of the waveguide-ports (114, 115) of said Vector Network Analyzer (VNA).

6. System according to any of the previous claims, comprising further a calibration kit, wherein said kit comprises:

- a first waveguide section (G1) in which electromagnetic waves propagate according to Na propagation modes and having a first length, the generalized scattering matrix of said first section being predetermined, in particular pre-calculated or pre-measured,
- a second waveguide section (G2) in which electromagnetic waves propagate according to Na propagation modes and having a second length, the generalized scattering matrix of said second section being predetermined, in particular pre-calculated or pre-measured,
- at least a waveguide element realizing a shifted short circuit (TSC); where said first length is different from said second length.

7. System according to claim 6, wherein:

- the transverse cross section of said first waveguide section (G1) is equal to the transverse cross section of said second waveguide section (G2), to the transverse cross section of the multimodal waveguide (140) of said first converter (T1), and to the cross section (150) of the multimodal waveguide of said second converter (T2),
- the transverse cross section of said second waveguide section (G2) is equal to the transverse cross section of said first waveguide section (G1), to the transverse cross section of the multimodal waveguide (140) of said first converter (T1), and to the transverse cross section of the multimodal waveguide (150) of said second converter (T2), and
- the transverse cross section of said waveguide element realizing a shifted short circuit (TSC) is equal to the transverse cross section of the multimodal waveguide (140) of said first converter (T1), and to the transverse cross section of the multimodal waveguide (150) of said second converter (T2).

8. Method for determining a generalized scattering matrix (GSM) of a hollow conducting waveguide device (DUT), said device (DUT) having at least a first (141) and a second (151) hollow conducting waveguide ports each being a multimodal port allowing propagation of a number of propagating modes Na greater than or equal to two, by means of a vector network analyzer (VNA) having at least a first group (112, 113) and a second group (114, 115) of waveguide ports each being a monomodal port allowing propagation of one propagation mode, and by means of a first and a second converters (T1, T2) adapted to the interface the hollow conducting waveguide ports of said device (DUT) to the waveguide ports of said analyzer (VNA); the method comprising the following steps:

A) connecting said first converter (T1) between the first hollow conducting waveguide port of said device (DUT) and the first group (112, 113) of waveguide ports of said analyzer (VNA),
B) connecting said second converter (T2) between the second hollow conducting waveguide port of said device (DUT) and the second group (114, 115) of waveguide ports of said analyzer (VNA),
C) performing a measurement of scattering parameters by means of said analyzer (VNA) of the connection between said device (DUT) and said first and second converters (T1, T2),
D) processing results of said measurement and generalized scattering matrices of said first and second converters (T1, T2) thus obtaining the generalized scattering matrix (GSM) of said device (DUT).

9. Method according to claim 8, wherein said analyzer (VNA) is calibrated preliminarily in way independent of said device (DUT) and of said first and second converters (T1, T2).

**10.** Method according to claim 9, wherein said analyzer (VNA) is calibrated in the frequency band of interest for example by using the procedure Thru-Reflect-Line (TRL) or Short-Open-Load-Thru (SOLT).

**11.** Method according to claims 8 or 9 or 10, wherein the generalized scattering matrices of said first and second converters (T1, T2) are determined by means of preliminary a calibration procedure dependent on said first and second converters (T1, T2) and independent of said device (DUT).

**12.** Method according to claim 11, wherein said calibration procedure comprises the following phases:

- connection of said first and second converters (T1, T2) to said analyzer (VNA) through their monomodal ports, connection of said first and second converters (T1, T2) by placing a first waveguide section (G1), having a first length, in between their multimodal ports and measurement of the scattering parameters of the scattering matrix $S_1$ by means of said analyzer (VNA) and their storage in a memory either external or internal to said analyzer (VNA),

- connection of said first and second converters (T1, T2) respectively to said analyzer (VNA) by means of the monomodal ports, connection of said first and second converters (T1, T2) by placing a second waveguide section (G2), having a second length, in between their multimodal ports, and measurement of the scattering parameters of the scattering matrix $S_2$ by means of said analyzer (VNA) and their storage in a memory either external or internal to said analyzer (VNA),

- connection of said first or second converter (T1, T2) directly to said analyzer (VNA) by means of the monomodal ports, connection of said first or second converter (T1, T2) directly to a waveguide element realizing a shifted short circuit (TSC) through the multimodal port, and measurement of the scattering parameters of the scattering matrix $\Gamma$ by means of said analyzer (VNA) and their storage in a memory either external or internal to said analyzer (VNA).

**13.** Method according to any of the previous claims 8 to 12, wherein said analyzer (VNA) has a number of monomodal waveguide ports, being equal to twice said number Na of propagating modes.

**14.** Method according to any of the previous claims 8 to 12, wherein said analyzer (VNA) has only two monomodal waveguide ports, and said only two ports are connected according to all possible combinations to said monomodal waveguide ports of said first and second converters (T1, T2) each time repeating measurement of scattering parameters.

**15.** Method according to any of the previous claims 8 to 14, **characterized by** the fact of using a system according to any of the claims 1 to 7.

**Patentansprüche**

**1.** System zur Bestimmung einer generalisierten Streumatrix (GSM) einer hohlen, leitenden Wellenleiter-Vorrichtung (DUT), wobei die Vorrichtung (DUT) zumindest einen ersten (141) und einen zweiten (151) hohlen, leitenden Wellenleiter-Anschluss aufweist, die jeweils multimodale Anschlüsse sind, die die Übertragung mehrerer Übertragungsmodi Na größer oder gleich zwei ermöglichen, wobei das System aufweist:

- einen Vektor-Netzwerkanalysator (VNA), der geeignet ist, Streuparameter zu messen und der zumindest eine erste Gruppe (112, 113) und eine zweite Gruppe (114, 115) von Wellenleiter-Anschlüssen aufweist, die jeweils monomodale Anschlüsse sind, die die Übertragung eines Übertragungsmodus ermöglichen,
- Mittel zur Umwandlung (T1, T2), die geeignet sind, die hohlen, leitenden Wellenleiter-Anschlüsse (141, 151) der Vorrichtung (DUT) mit den Wellenleiter-Anschlüssen (112, 113, 114, 115) des Analysators (VNA) zu verbinden, wenn das System zum Bestimmen genutzt wird, und
- Mittel zur Speicherung und Datenverarbeitung, die geeignet sind, die Berechnung der generalisierten Streumatrix (GSM) der hohlen, leitenden Vorrichtung (DUT) gemäß der mittels des Analysators (VNA) gemessenen Daten von Streuparametern und gemäß bereits gespeicherter Kalibrierungsdaten durchzuführen und zu speichern;

wobei die Mittel zur Umwandlung (T1, T2) zumindest aufweisen:

- einen ersten Konverter (T1) mit einem hohlen, leitenden Wellenleiter-Anschluss (140) zur Verbindung mit dem ersten hohlen, leitenden Wellenleiter-Anschluss (141) der Vorrichtung (DUT) und mit einer Anzahl von Wellenleiter-Anschlüssen (161, 162), die der Anzahl Na zum Verbinden mit dem Analysator (VNA) entspricht, und
- einen zweiten Konverter (T2) mit einem hohlen, leitenden Wellenleiter-Anschluss (150) zur Verbindung mit dem ersten hohlen, leitenden Wellenleiter-Anschluss (151) der Vorrichtung (DUT) und mit einer Anzahl von Wellenleiter-Anschlüssen (181, 182), die der Anzahl Na zum Verbinden mit dem Analysator (VNA) entspricht.

2.   System gemäß Anspruch 1, wobei:

- der Wellenleiter-Anschluss (140) des ersten Konverters (T1) zum Verbinden mit der Vorrichtung (DUT) ein physikalischer Anschluss ist, entsprechend einer Vielzahl elektrischer Anschlüsse und aus einem multimodalen Wellenleiter besteht, wobei sich die Na-Modi, die den Na elektrischen Anschlüssen entsprechen, übertragen können,
- die Anzahl der Wellenleiter-Anschlüsse (161, 162) des ersten Konverters (T1) zum Verbinden mit dem Analysator (VNA) physikalische Anschlüsse sind, die ebenso vielen elektrischen Anschlüssen entsprechen und entsprechend aus monomodalen Anschlüssen bestehen,
- der Wellenleiter-Anschluss (150) des zweiten Konverters (T2) zum Verbinden mit der Vorrichtung (DUT) ein physikalischer Anschluss ist, der einer Vielzahl elektrischer Anschlüsse entspricht und aus einem multimodalen Wellenleiter besteht, wobei die Na-Modi, die den Na elektrischen Anschlüssen entsprechen, übertragen können,und
- die Anzahl der Wellenleiter-Anschlüsse (181, 182) des zweiten Konverters (T2) zum Verbinden mit dem Analysator (VNA) physikalische Anschlüsse sind, die ebenso vielen elektrischen Anschlüssen entsprechen und entsprechend aus monomodalen Anschlüssen bestehen.

3.   System gemäß einem der Ansprüche 1 oder 2, wobei der transversale Querschnitt des multimodalen Wellenleiters (140) des ersten Konverters (T1) gleich dem transversalen Querschnitt des multimodalen Wellenleiters (150) des zweiten Konverters (T2) ist.

4.   System gemäß einem der Ansprüche 1 oder 2 oder 3, wobei der transversale Querschnitt der monomodalen Wellenleiter (161, 162) des ersten Konverters (T1) gleich dem transversalen Querschnitt der monomodalen Wellenleiter (181, 182) des zweiten Konverters (T2) ist.

5.   System gemäß einem der Ansprüche 1 oder 2 oder 3 oder 4, wobei:

- der transversale Querschnitt der monomodalen Wellenleiter (161, 162) des ersten Konverters (T1) gleich dem transversalen Querschnitt der Wellenleiter-Anschlüsse (112, 113) des Vektor-Netzwerkanalysators (VNA) ist und
- der transversale Querschnitt der monomodalen Wellenleiter (181, 182) des zweiten Konverters (T2) gleich dem transversalen Querschnitt der Wellenleiter-Anschlüsse (114, 115) des Vektor-Netzwerkanalysators (VNA) ist.

6.   System gemäß einem der vorigen Ansprüche, weiter aufweisend ein Kalibrierungs-Set, wobei das Set aufweist:

- einen ersten Wellenleiter-Bereich (G1) in dem sich elektromagnetische Wellen gemäß Na-Übertragungsmodi ausbreiten und eine erste Länge aufweisen, wobei die generalisierte Streumatrix des ersten Bereichs vorgegeben, insbesondere vorberechnet oder vorher gemessen ist,
- einen zweiten Wellenleiter-Bereich (G2) in dem sich elektromagnetische Wellen gemäß Na-Übertragungsmodi ausbreiten und eine zweite Länge aufweisen, wobei die generalisierte Streumatrix des zweiten Bereichs vorgegeben, insbesondere vorberechnet oder vorher gemessen ist,
- zumindest ein Wellenleiter-Element, das einen verschobenen Kurzschluss (TSC) durchführt, wobei sich die erste Länge von der zweiten Länge unterscheidet.

7.   System gemäß Anspruch 6, wobei:

- der transversale Querschnitt des ersten Wellenleiter-Bereichs (G1) gleich dem transversalen Querschnitt des zweiten Wellenleiter-Bereichs (G2), dem transversalen Querschnitt des multimodalen Wellenleiters (140) des ersten Konverters (T1) und dem Querschnitt des multimodalen Wellenleiters (150) des zweiten Konverters (T2) ist,
- der transversale Querschnitt des zweiten Wellenleiter-Bereichs (G2) gleich dem transversalen Querschnitt des ersten Wellenleiter-Bereichs (G1), dem transversalen Querschnitt des multimodalen Wellenleiters (140) des ersten Konverters (T1) und dem transversalen Querschnitt des multimodalen Wellenleiters (150) des zweiten Konverters (T2) ist und

- der transversale Querschnitt des Wellenleiter-Elements, das einen verschobenen Kurzschluss (TSC) durchführt, gleich dem transversalen Querschnitt des multimodalen Wellenleiters (140) des ersten Konverters (T1) und dem transversalen Querschnitt des multimodalen Wellenleiters (150) des zweiten Konverters (T2) ist.

8. Verfahren zur Bestimmung einer generalisierten Streumatrix (GSM) einer hohlen, leitenden Vorrichtung (DUT), wobei die Vorrichtung (DUT) zumindest einen ersten (141) und einen zweiten (151) hohlen, leitenden Wellenleiter-Anschluss aufweist, die jeweils multimodale Anschlüsse sind, die die Übertragung mehrerer Übertragungsmodi Na größer oder gleich zwei mittels

eines Vektor-Netzwerkanalysators (VNA) ermöglichen, der eine erste Gruppe (112, 113) und eine zweite Gruppe (114, 115) von Wellenleiter-Anschlüssen aufweist, die jeweils monomodale Anschlüsse sind, die die Übertragung eines Übertragungsmodus ermöglichen, und

mittels eines ersten und zweiten Konverters (T1, T2), die geeignet sind, die hohlen, leitenden Wellenleiter-Anschlüsse der Vorrichtung (DUT) mit den Wellenleiter-Anschlüssen des Analysators (VNA) zu verbinden, wobei das Verfahren die folgenden Schritte aufweist:

A) Verbinden des ersten Konverters (T1) zwischen dem ersten hohlen, leitenden Wellenleiter-Anschluss der Vorrichtung (DUT) und der ersten Gruppe (112, 113) von Wellenleiter-Anschlüsse des Analysators (VNA),
B) Verbinden des zweiten Konverters (T2) zwischen dem zweiten hohlen, leitenden Wellenleiter-Anschluss der Vorrichtung (DUT) und der zweiten Gruppe (114, 115) von Wellenleiter-Anschlüssen des Analysators (VNA),
C) Durchführen einer Messung von Streuparametern der Verbindung zwischen dem Leiter (DUT) und dem ersten und zweiten Konverter (T1, T2) mittels des Analysators (VNA),
D) Berechnung der Ergebnisse aus der Messung und der generalisierten Streumatrizen des ersten und zweiten Konverters (T1, T2), zum Erhalten der generalisierte Streumatrix (GSM) der Vorrichtung (DUT).

9. Verfahren gemäß Anspruch 8, wobei der Analysator (VNA) vorläufig unabhängig von der Vorrichtung (DUT) und dem ersten und zweiten Konverter (T1, T2) kalibriert wird.

10. Verfahren gemäß Anspruch 9, wobei der Analysator (VNA) im bevorzugten Frequenzbereich kalibriert wird, z. B. durch das Thru-Reflect-Line-Verfahren (TRL) oder das Short-Open-Load-Thru-Verfahren (SOLT).

11. Verfahren gemäß einem der Ansprüche 8 oder 9 oder 10, wobei die generalisierten Streumatrizen des ersten und zweiten Konverters (T1, T2) durch einen Kalibriervorgang ermittelt werden, in Abhängigkeit des ersten und zweiten Konverters (T1, T2) aber unabhängig von der Vorrichtung (DUT).

12. Verfahren gemäß Anspruch 11, wobei der Kalibriervorgang die folgenden Schritte aufweist:

- Verbinden des ersten und zweiten Konverters (T1, T2) mit dem Analysator (VNA) über deren monomodale Anschlüsse, Verbinden des ersten und zweiten Konverters (T1, T2) durch Zwischenschalten eines ersten Wellenleiter-Bereichs (G1) mit einer ersten Länge zwischen deren multimodale Anschlüsse und Messen der Streuparameter der Streumatrix $S_1$ mittels des Analysators (VNA) und Speichern derselbigen, entweder in einem externen oder einem internen Speicher des Analysators (VNA),
- Verbinden des ersten und zweiten Konverters (T1, T2) mit dem Analysator (VNA) über deren monomodale Anschlüsse, Verbinden des ersten und zweiten Konverters (T1, T2) durch Zwischenschalten eines zweiten Wellenleiter-Bereichs (G2) mit einer zweiten Länge zwischen deren multimodale Anschlüsse und Messen der Streuparameter der Streumatrix $S_2$ mittels des Analysators (VNA) und Speichern derselbigen, entweder in einem externen oder einem internen Speicher des Analysators (VNA),
- Verbinden des ersten oder zweiten Konverters (T1, T2) direkt mit dem Analysator (VNA) über deren monomodale Anschlüsse, Verbinden des ersten oder zweiten Konverters (T1, T2) direkt mit einem Wellenleiter-Element, das einen verschobenen Kurzschluss (TSC) durch den multimodalen Anschluss hindurch durchführt, und Messen der Streuparameter der Streumatrix I' mittels des Analysators (VNA) und Speichern derselbigen in einem externen oder internen Speicher des Analysators (VNA).

13. Verfahren gemäß einem der vorherigen Ansprüche 8 bis 12, wobei der Analysator (VNA) mehrere monomodale Wellenleiter-Anschlüsse aufweist, deren Anzahl das Doppelte der Na-Übertragungsmodi beträgt.

**14.** Verfahren gemäß einem der vorherigen Ansprüche 8 bis 12, wobei der Analysator (VNA) lediglich zwei monomodale Wellenleiter-Anschlüsse aufweist, und Verbinden dieser lediglich zwei Anschlüsse in allen möglichen Kombinationen bei jeder Wiederholung der Messung der Streuparameter mit den monomodalen Wellenleiter-Anschlüssen des ersten und zweiten Konverters (T1, T2).

**15.** Verfahren gemäß einem der vorherigen Ansprüche 8 bis 14, **dadurch gekennzeichnet, dass** ein System gemäß einem der Ansprüche 1 bis 7 verwendet wird.

**Revendications**

**1.** Système pour la détermination d'une matrice de diffusion généralisée (GSM) d'un dispositif de guide d'ondes conducteur creux (DUT), ledit dispositif (DUT) ayant au moins un premier (141) et un deuxième (151) port de guide d'ondes conducteur creux chacun étant un port multimodal permettant la propagation d'un certain nombre de modes de propagation Na supérieur ou égal à deux ;
le système comprenant :

- un analyseur de réseau vectoriel (VNA) adapté pour mesurer des paramètres de diffusion et ayant au moins un premier groupe (112, 113) et un deuxième groupe (114, 115) de ports de guide d'ondes, chacun étant un port monomodal permettant la propagation d'un mode de propagation,
- des moyens de conversion (T1, T2) adaptés pour interfacer les ports de guide d'ondes conducteur creux (141, 151) dudit dispositif (DUT) aux ports de guide d'ondes (112, 113, 114, 115) dudit analyseur (VNA) quand le système est utilisé pour la détermination, et
- des moyens de traitement de données et de stockage adaptés pour mettre en oeuvre le calcul de la matrice de diffusion généralisée (GSM) dudit dispositif de guide d'ondes conducteur creux (DUT) en fonction de données de paramètre de diffusion mesurées au moyen dudit analyseur (VNA) et ensuite stockées, et en fonction de données d'étalonnage préalablement stockées ;

dans lequel lesdits moyens de conversion (T1, T2) comprennent au moins :

- un premier convertisseur (T1) ayant un port de guide d'ondes conducteur creux (140) pour une connexion audit premier port de guide d'ondes conducteur creux (141) dudit dispositif (DUT) et un certain nombre de ports de guide d'ondes (161, 162) égal audit nombre Na pour une connexion audit analyseur (VNA), et
- un deuxième convertisseur (T2) ayant un port de guide d'ondes conducteur creux (150) pour une connexion audit deuxième port de guide d'ondes conducteur creux (151) dudit dispositif (DUT) et un certain nombre de ports de guide d'ondes (181, 182) égal audit nombre Na pour une connexion audit analyseur (VNA).

**2.** Système selon la revendication 1, dans lequel :

- ledit port de guide d'ondes (140) dudit premier convertisseur (T1) pour la connexion au dispositif (DUT) est un port physique correspondant à une pluralité de ports électriques et il consiste en un guide d'ondes multimodal où lesdits Na modes, correspondant à Na ports électriques, peuvent se propager,
- ledit nombre de ports de guide d'ondes (161, 162) dudit premier convertisseur (T1) pour la connexion à l'analyseur (VNA) sont des ports physiques correspondant à autant de ports électriques et consistent en des ports monomodaux respectivement,
- ledit port de guide d'ondes (150) dudit deuxième convertisseur (T2) pour la connexion au dispositif (DUT) est un port physique correspondant à une pluralité de ports électriques et il consiste en un guide d'ondes multimodal où lesdits Na modes, correspondant à Na ports électriques, peuvent se propager, et
- ledit nombre de ports de guide d'ondes (181, 182) dudit deuxième convertisseur (T2) pour la connexion à l'analyseur (VNA) sont des ports physiques correspondant à autant de ports électriques et consistent en des ports monomodaux respectivement.

**3.** Système selon les revendications 1 ou 2, dans lequel :

la section transversale du guide d'ondes multimodal (140) dudit premier convertisseur (T1) est égale à la section transversale du guide d'ondes multimodal (150) dudit deuxième convertisseur (T2).

**4.** Système selon les revendications 1 ou 2 ou 3, dans lequel :

- la section transversale des guides d'ondes monomodaux (161, 162) dudit premier convertisseur (T1) est égale à la section transversale des guides d'ondes monomodaux (181, 182) dudit convertisseur (T2).

5. Système selon les revendications 1 ou 2 ou 3 ou 4, dans lequel :

- la section transversale des guides d'ondes monomodaux (161, 162) dudit premier convertisseur (T1) est égale à la section transversale des ports de guide d'ondes (112, 113) dudit analyseur de réseau vectoriel (VNA), et
- la section transversale des guides d'ondes monomodaux (181, 182) dudit deuxième convertisseur (T2) est égale à la section transversale des ports de guide d'ondes (114, 115) dudit analyseur de réseau vectoriel (VNA).

6. Système selon l'une quelconque des revendications précédentes, comprenant en outre un kit d'étalonnage, dans lequel ledit kit comprend :

- une première section de guide d'ondes (G1) dans laquelle des ondes électromagnétiques se propagent selon Na modes de propagation et ayant une première longueur, la matrice de diffusion généralisée de ladite première section étant prédéterminée, en particulier préalablement calculée ou préalablement mesurée,
- une deuxième section de guide d'ondes (G2) dans laquelle des ondes électromagnétiques se propagent selon Na modes de propagation et ayant une deuxième longueur, la matrice de diffusion généralisée de ladite deuxième section étant prédéterminée, en particulier préalablement calculée ou préalablement mesurée,
- au moins un élément de guide d'ondes réalisant un court-circuit décalé (TSC) ;
où ladite première longueur est différente de ladite deuxième longueur.

7. Système selon la revendication 6, dans lequel :

- la section transversale de ladite première section de guide d'ondes (G1) est égale à la section transversale de ladite deuxième section de guide d'ondes (G2), à la section transversale du guide d'onde multimodal (140) dudit premier convertisseur (T1), et à la section transversale (150) du guide d'ondes multimodal dudit deuxième convertisseur (T2),
- la section transversale de ladite deuxième section de guide d'ondes (G2) est égale à la section transversale de ladite première section de guide d'ondes (G1), à la section transversale du guide d'onde multimodal (140) dudit premier convertisseur (T1), et à la section transversale du guide d'ondes multimodal (150) dudit deuxième convertisseur (T2), et
- la section transversale dudit élément de guide d'ondes réalisant un court-circuit décalé (TSC) est égale à la section transversale du guide d'ondes multimodal (140) dudit premier convertisseur (T1), et à la section transversale du guide d'ondes multimodal (150) dudit deuxième convertisseur (T2).

8. Procédé pour la détermination d'une matrice de diffusion généralisée (GSM) d'un dispositif de guide d'ondes conducteur creux (DUT), ledit dispositif (DUT) ayant au moins un premier (141) et un deuxième (151) port de guide d'ondes conducteur creux chacun étant un port multimodal permettant la propagation d'un certain nombre de modes de propagation Na supérieur ou égal à deux, au moyen d'un analyseur de réseau vectoriel (VNA) ayant au moins un premier groupe (112, 113) et un deuxième groupe (114, 115) de ports de guide d'ondes chacun étant un port monomodal permettant la propagation d'un mode de propagation, et au moyen d'un premier et d'un deuxième convertisseur (T1, T2) adaptés pour interfacer les ports de guide d'ondes conducteur creux dudit dispositif (DUT) aux ports de guide d'ondes dudit analyseur (VNA) ; le procédé comprenant les étapes suivantes :

A) la connexion dudit premier convertisseur (T1) entre le premier port de guide d'ondes conducteur creux dudit dispositif (DUT) et le premier groupe (112, 113) de ports de guide d'ondes dudit analyseur (VNA),
B) la connexion dudit deuxième convertisseur (T2) entre le deuxième port de guide d'ondes conducteur creux dudit dispositif (DUT) et le deuxième groupe (114, 115) de ports de guide d'ondes dudit analyseur (VNA),
C) la mise en oeuvre d'une mesure de paramètres de diffusion au moyen dudit analyseur (VNA) de la connexion entre ledit dispositif (DUT) et lesdits premier et deuxième convertisseurs (T1, T2),
D) le traitement des résultats de ladite mesure et des matrices de diffusion généralisée desdits premier et deuxième convertisseurs (T1, T2) pour ainsi obtenir la matrice de diffusion généralisée (GSM) dudit dispositif (DUT).

9. Procédé selon la revendication 8, dans lequel ledit analyseur (VNA) est étalonné au préalable d'une manière indépendante dudit dispositif (DUT) et desdits premier et deuxième convertisseurs (T1, T2).

**10.** Procédé selon la revendication 9, dans lequel ledit analyseur (VNA) est étalonné dans la bande de fréquences d'intérêt par exemple en utilisant la procédure Thru-Reflect-Line (TRL) ou Short-Open-Load-Thru (SOLT).

**11.** Procédé selon les revendications 8 ou 9 ou 10, dans lequel les matrices de diffusion généralisée desdits premier et deuxième convertisseurs (T1, T2) sont déterminées au moyen d'une procédure d'étalonnage préliminaire dépendante desdits premier et deuxième convertisseurs (T1, T2) et indépendante dudit dispositif (DUT).

**12.** Procédé selon la revendication 11, dans lequel ladite procédure d'étalonnage comprend les phases suivantes :

   - la connexion desdits premier et deuxième convertisseurs (T1, T2) audit analyseur (VNA) par l'intermédiaire de leurs ports monomodaux, la connexion desdits premier et deuxième convertisseurs (T1, T2) par le placement d'une première section de guide d'ondes (G1), ayant une première longueur, entre leurs ports multimodaux et la mesure des paramètres de diffusion de la matrice de diffusion $S_1$ au moyen dudit analyseur (VNA) et leur stockage dans une mémoire soit externe, soit interne audit analyseur (VNA),
   - la connexion desdits premier et deuxième convertisseurs (T1, T2) respectivement audit analyseur (VNA) au moyen des ports monomodaux, la connexion desdits premier et deuxième convertisseurs (T1, T2) par le placement d'une deuxième section de guide d'ondes (G2), ayant une deuxième longueur, entre leurs ports multimodaux, et la mesure des paramètres de diffusion de la matrice de diffusion $S_2$ au moyen dudit analyseur (VNA) et leur stockage dans une mémoire soit externe, soit interne audit analyseur (VNA),
   - la connexion desdits premier et deuxième convertisseurs (T1, T2) directement audit analyseur (VNA) au moyen des ports monomodaux, la connexion desdits premier et deuxième convertisseurs (T1, T2) directement à un élément de guide d'ondes réalisant un court-circuit décalé (TSC) par l'intermédiaire du port multimodal, et la mesure des paramètres de diffusion de la matrice de diffusion $\Gamma$ au moyen dudit analyseur (VNA) et leur stockage dans une mémoire soit externe, soit interne audit analyseur (VNA).

**13.** Procédé selon l'une quelconque des revendications 8 à 12 précédentes, dans lequel ledit analyseur (VNA) possède un certain nombre de ports de guide d'ondes monomodal, égal à deux fois ledit nombre Na de modes de propagation.

**14.** Procédé selon l'une quelconque des revendications 8 à 12 précédentes, dans lequel ledit analyseur (VNA) possède seulement deux ports de guide d'ondes monomodal, et lesdits seulement deux ports sont connectés selon toutes les combinaisons possibles auxdits ports de guide d'ondes monomodal desdits premier et deuxième convertisseurs (T1, T2) en répétant à chaque fois la mesure des paramètres de diffusion.

**15.** Procédé selon l'une quelconque des revendications 8 à 14 précédentes, **caractérisé par** le fait d'utiliser un système selon l'une quelconque des revendications 1 à 7.

Fig.1

Fig.2

320

310

330

300

Fig.3

EP 2 646 840 B1

Fig.4

```
┌─────────────────────────────────────────────────────────────┐
│                Standard calibration of the VNA           ●    │──── 510
└─────────────────────────────────────────────────────────────┘
                              │
                              ▼
┌─────────────────────────────────────────────────────────────┐
│   Connection of the converters to the VNA through monomodal ports ● │──── 520
└─────────────────────────────────────────────────────────────┘
                              │
                              ▼
┌─────────────────────────────────────────────────────────────┐
│ Measurement of the scattering matrices of the waveguide sections and of │
│ the short or shifted short connected to the waveguide-ports (multimodal) │
│ of the converters. Measurement is performed at the monomodal ports ●     │──── 530
│                    of the converters                          │
└─────────────────────────────────────────────────────────────┘
                              │
                              ▼
┌─────────────────────────────────────────────────────────────┐
│   Building of the generalized scattering matrices of the two converters ● │──── 540
└─────────────────────────────────────────────────────────────┘
                              │
                              ▼
┌─────────────────────────────────────────────────────────────┐
│ Measurement of the scattering matrix of the DUT, when connected to the │
│    waveguide-ports (multimodal) of the converters. Measurement is       │
│       performed at the monomodal ports of the converters. ●             │──── 550
└─────────────────────────────────────────────────────────────┘
                              │
                              ▼
┌─────────────────────────────────────────────────────────────┐
│     Correction of the sistematic error due to the converters and        │
│      calculation of the generalized scattering matrix of the DUT ●      │──── 560
└─────────────────────────────────────────────────────────────┘
```

500

Fig.5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004201383 A, Anderson Keith F

**Non-patent literature cited in the description**

- **COLLIN.** Field Theory of Guided Waves. IEEE Press, 1992
- **MARCUVITZ.** Waveguide Handbook. 1987
- **MONTGOMERY ; DICKE ; PURCELL.** Principles of Microwave Circuits. 1987
- **J. UHER ; J. BORNEMANN ; U. ROSENBERG.** Waveguide. Components for Antenna Feed Systems: Theory and CAD. Artech House, 1993
- **I. BAHL ; P. BHARTIA.** Microwave Solid State Circuit Design. Wiley, 2003